Europäisches Patentamt

European Patent Office

Office européen des brevets

(19)

(11) Publication number: 0 156 412
A1

# (12) EUROPEAN PATENT APPLICATION

(21) Application number: 85200247.6

(22) Date of filing: 25.02.85

(51) Int. Cl.⁴: H 01 S 3/09
H 01 S 3/101, H 01 J 1/30
G 11 B 7/125, G 11 B 7/09
G 06 K 7/14

(30) Priority: 29.02.84 NL 8400632

(43) Date of publication of application:
02.10.85 Bulletin 85/40

(84) Designated Contracting States:
AT DE FR GB IT NL

(71) Applicant: N.V. Philips' Gloeilampenfabrieken
Groenewoudseweg 1
NL-5621 BA Eindhoven(NL)

(72) Inventor: Van Ruyven, Lodewijk Johan
c/o Int. Octrooibureau B.V. Prof. Holstlaan 6
NL-5656 AA Eindhoven(NL)

(74) Representative: Raap, Adriaan Yde et al,
INTERNATIONAAL OCTROOIBUREAU B.V. Prof.
Holstlaan 6
NL-5656 AA Eindhoven(NL)

(54) Device for producing electromagnetic radiation.

(57) When by means of electrons of high energy (7) generated by a semiconductor cathode (20) population inversion is obtained in an active region (2) of a laser structure (1), a laser action is obtained. This laser action can be restricted to a narrow strip (3) of the active region (2). By means of deflection means (10,21) preferably constituted by acceleration electrodes (21) of the semiconductor cathode (20), the position of the narrow strip (3) in which inversion occurs and hence the position of the emanating electromagnetic beam (6) can be varied. Such a displacing beam (6) can be used for scanning (writing) information carriers (CD, DOR, VLP-, videotape).

EP 0 156 412 A1

0156412

Device for producing electromagnetic radiation.

The invention relates to a device for producing coherent electromagnetic radiation comprising at least a first body provided with a first layer of a material suitable for producing electromagnetic radiation having an active region, in which in the operative condition population inversion is obtained by means of electron injection, which device comprises at least a cathode for generating an electron beam striking the active region and causing population inversion for producing the electromagnetic radiation in a strip of the active region which is narrow with respect to the width of the active region, while by control of the electron beam the position of the strip in the active region and hence the position of the emanating radiation can be varied.

The invention further relates to an optical reading unit and writing unit, respectively, provided with such a device.

A device of the kind mentioned in the opening paragraph is known from US P 3,655,986. This Patent shows a laser which is formed by providing on the end wall of a vacuum tube a layer of optically active material. During operation, population inversion is obtained in the active layer in that the active layer is struck by electrons originating from a thermionic cathode.

The electromagnetic beam produced by such a laser can be caused to be displaced continuously in the direction of width by electromechanical auxiliary means. Such a displacement is desired, for example, with the use for reading bar codes or for reading, tracking or rotating image and sound carriers, respectively (VLP, DOR, Compact Disc, video recorders).

A device according to the invention is characterized in that the device comprises a semiconductor cathode for generating an electron beam.

A device according to the invention can then be constructed as a very small vacuum tube, in which the first body with the active layer is provided at the area of the target. Such a vacuum tube can be very small in a given embodiment of the semi-conductor cathode due to the fact that a "virtual" focus can be chosen effectively for the electron source constituting the semiconductor cathode. This is explained more fully in Netherlands Patent Application No. 7905470 of the Applicant, in which the remaining advantages of such a cathode are also described, such as especially the uniform speed distribution of the electrons, the simple electron-optical system of the tube and the rapid switching time as compared with thermionic cathode. Although various kinds of cathodes may be chosen for the semiconductor cathode, for example negative electron affinity cathodes or the cathodes of the kind described in Netherlands Patent Application No. 7800987 or, for example, in British Patent Application No. 8133501, this cathode preferably comprises, however, a semi-conductor body with a pn junction between an n-type region adjoining a surface of the semiconductor body and a p-type region, while due to the application of a voltage in the reverse direction across the pn junction in the semiconductor body electrons are generated by avalanche multiplication, which emanate from the semiconductor body, the pn junction at least locally extending substantially parallel to the surface and having a lower breakdown voltage than the remaining part of the pn junction, the part having the lower breakdown voltage being separated from the surface by an n-type conducting layer having such a thickness and doping that at the breakdown voltage the depletion zone of the pn junction does not extend as far as the surface, but remains separated from it by a surface layer which is sufficiently thin to allow the generated electrons to pass, while the surface of the semiconductor body is provided with an insulating layer in which at least one opening is formed, an acceleration electrode being provided on the insulating layer along the edge.

By such a device, a laser beam can be produced which emanates in a direction parallel to the strip in which population inversion occurs. This strip can be displaced throughout the width of the active region, for example with the aid of electrical voltages at auxiliary electrodes of the semiconductor cathode or with the aid of electromagnetic deflection means. The laser beam produced can be imaged by means of a lens system, for example on an information carrier, while the radiation reflected from this information carrier can be read in a usual manner for direct information processing or feedback circuits.

The said advantages occur especially if the strip in which population inversion is obtained is narrow with respect to the overall width of the active region. This latter region is preferably more than 10 times larger (for example 20 to 100 times larger) than the relevant strip.

The active region preferably comprises a layer of monocrystalline semiconductor material from a II-VI compound or a III-V compound. These compounds generally have a larger forbidden band with and therefore give rise to radiation of shorter wavelength.

A III-V compound is to be understood herein to mean a compound of at least one element from the group comprising boron (B), aluminium (Al), gallium (Ga), indium (In) and thallium (Tl) with at least one element of the group comprising nitrogen (N), phosphorus (P), arsenic (As), antimony (Sb) and bismuth (Bi).

A II-VI compound is to be understood herein to mean a compound of at least one element from the group comprising zinc (Zn), cadmium (Cd) and mercury (Hg) with at least one element from the group comprising oxygen (O), sulphur (S), selenium (Se) and tellurium (Te).

In order to obtain a specific wavelength, these compounds may be doped, if desired, with given dopants.

A device according to the invention may advantageously be used in an optical reading unit for scanning a record carrier which is provided with a radiation-reflecting information structure arranged in the form of a strip, this reading unit comprising an objective system for focusing a reading beam on an information structure and a radiation source as well as a detection unit for the reflected beam.

An optical reading unit is to be understood to mean the assembly of the means which ensure that a reading beam is produced, that this beam is focused to a reading spot of the desired dimensions on the information structure and that the reflected reading beam is converted into an electrical signal. A "strip-shaped" information carrier is to be understood to mean a structure of which the information details are arranged according to substantially parallel tracks, such as, for example, a bar code on articles.

For further data processing, such a reading unit preferably generates a binary signal which is related to the width of the strip-shaped parts of the information structure (or the complement thereof). The binary signal thus obtained is then further processed in a processor, which may form part of the reading unit.

A device according to the invention may also be used in an optical reading unit for scanning - when a record carrier and this reading unit are moved relative to each other - the record carrier, which is provided with a radiation-reflecting information structure arranged in the form of a track, this reading unit comprising an objective system for focusing a reading beam on the information structure and a radiation source as well as a detection unit for the reflected beam.

An information structure "arranged in the form of a track" is to be understood to mean a structure, of which the information details are arranged either according to concentric or quasi concentric tracks, the latter tracks constituting together a continuous helical track, or according to substantially parallel tracks, such as, for example, in digitial optical recording on a tape.

Such a reading unit may be used in apparatus for sound or image recording (compact disc, DOR, VLP). In the "Compact Disc" system of the kind described in the article "Het Systeem "Compact Disc Digital Audio"", published in "Philips Technisch Tijdschrift" 40, p. 267-272, 1981/2, No.9, a given asymmetry can be obtained for the reflected beam due to ageing or contamination of the optical system. Due to a direct voltage component in a tracking error signal not described here further, the luminous spot is then invariably situated slightly beside the centre of the track. In order to compensate for this effect, a second tracking error signal is produced. For this purpose, a coil controlling the arm of the reading unit is provided with an alternating voltage of, for example, 600 Hz having an amplitude which leads to a given radial displacement (for example 0.05 /um) of the luminous spot on the information carrier. The outgoing sum signal of, for example, four photodiodes (in the detection unit) for focusing and the first tracking error signal, this sum signal being a maximum when the luminous spot is situated at the centre of the track, is thus modulated with the alternating voltage of 600 Hz. The amplitude of this 600 Hz signal increased as the luminous spot is removed further from the centre of the track. Moreover, the sign of this signal changes when the luminous spot is displaced to the other side of the track. This second tracking error signal can then be used to correct the aforementioned error signal with a direct voltage. The outgoing sum signal of the photo-diodes consequently becomes a maximum again.

Due to the fact that in the reading unit according to the invention the radial displacement of the luminous spot is obtained by a voltage variation at the acceleration electrode of the semiconductor cathode (or by electromagnetic means), the coil for supplying the alternating voltage may be dispensed with. This means that a "compact Disk" device can now be given, for example, a rigid sliding construction, the reading unit moving along a guiding rod or carriage driven by, for example, a linear motor. Thus, a very shock-proof construction is obtained so that such a device is suitable to be built in, for example, in automobiles.

With the use of such a reading unit in the VLP system, an indication about the length of the information pits can be obtained by means of the lateral displacement produced by the device according to the invention provided that this displacement takes place at a sufficiently high frequency. This length inter alia determines the colour coding. In a usual system, the reflected light beam is inter alia conducted to a detector via a controllable tilting mirror. This also applies to the reflected beams for focusing and tangential tracking. A disadvantage of such a system is that, in order to maintain the correct adjustment, these mirrors have to be locked when the apparatus is displaced.

In a reading device according to the invention, the length of the pits (tangential tracking) can be determined by causing the luminous spot to move at a high frequency transverse to the track. If the device has an arm controllable by a coil and analogous to that for the known
"Compact Disc" device described above, the other adjustment
mechanisms (focusing, radial tracking) can be effected in
the manner known for this device.

Thus, an optical reading unit is obtained suitable
for applications for VLP, which can be constructed in a
simple manner.Moreover, in such a reading unit, the tilting
mirrors may be dispensed with. Thus, since it is no longer
required to lock these mirror before the apparatus is displaced, an apparatus is obtained that can be more readily
manipulated and has a higher resistance to shock.

The device according to the invention may be used
in a manner similar to that described for reading units in
a writing unit.

The invention will now be described more fully
with reference to a few embodiments and the drawing,
in which:

Figure 1 illustrates the operation of a device
according to the invention,

Figure 2 shows a cross-section of a semi-conductor
cathode for use in a device according to the invention,
while

Figure 3 shows diagrammatically in cross-section
an optical reading unit according to the invention and

Figure 4 shows diagrammatically in elevation such
a reading unit.

The Figures are schematic and not drawn to scale,
while for the sake of clarity in the cross-section of the
semiconductor cathode especially the dimensions in the
direction of thickness are greatly exaggerated. Semiconductor
zones of the same conductivity type are generally crosshatched in the same direction. In the Figures, corresponding
parts are generally designated by the same reference
numerals.

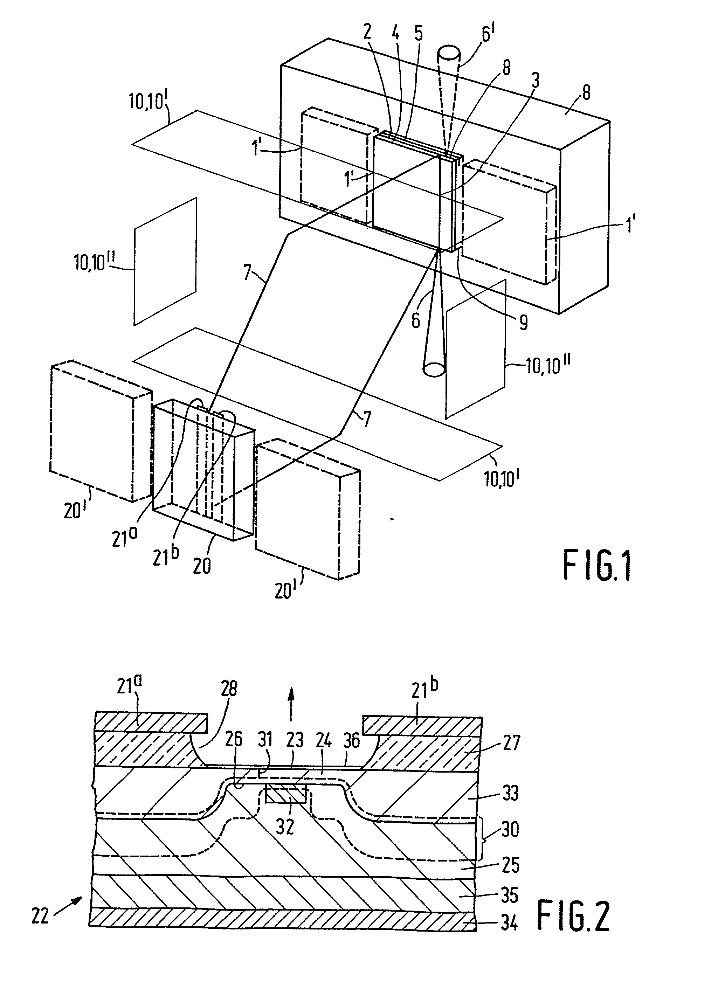

Figure 1 illustrates diagrammatically the
operation of the device according to the invention.

By means of a semiconductor cathode 20, an
electron beam 7 is produced, which strikes the body 1.

The electrons strike the body 1 comprising a first layer with an active region 2 according to a strip-shaped pattern 3 and thus lead to population inversion in the strip-shaped part of the region 2 struck according to the pattern 3. Population inversion exists if a higher energy level is occupied more strongly than a lower energy level. Such a population inversion is necessary to obtain laser action in the active region 2. The active layer 2 in this example comprises aluminium gallium arsenic $(Al_xGa_{1-x}As)$, where $x = 0.16$, and lies between coating layers 4 and 5 also consisting of $Al_xGa_{1-x}As$, where $x = 0.46$. Due to the difference in refractive index between the coating layer 4,5 and the active layer 2, the generated light remains enclosed in the active layer 2. In order to obtain laser action in the strip-shaped region 3, the latter is situated between the end faces 8 and 9, which constitute a resonator and are cleavage surfaces of a crystal. The end faces 8,9 act as semi-transparent mirrors, the electromagnetic radiation produced represented as beam 6,6' emanating at the area of the strip-shaped region 3 through these end faces. If required, the end wall 8 may be made completely reflecting so that only one beam 6 emanates.

The electron beam 7 may be imaged by means of electromagnetic deflection means 10 on the strip-shaped region 3, wherein, for example a target having a circular surface is continuously varied by means of vertical deflection means 10' throughout the strip-shaped region 3. Furthermore, if the semiconductor cathode 20 has a strip-shaped emission pattern, this pattern may be imaged on the active region 2, as the case may be in enlarged or reduced form. If the surface of the emission pattern has practically the same width and has at least the same length as the desired surface of the strip-shaped region, this emission pattern can be imaged practically on a scale of 1 : 1. The vertical deflection means 10' may then be dispensed with.

The body 1 and hence the active region 2 have a sufficient width to cause the position of the strip-shaped region 3 to vary. This may be obtained, for example, by means of the horizontal deflection plates 10" of the deflection means 10, which then results in a displacement of the beam 6. The horizontal deflection of the electron beam 7 may also be obtained, if desired, by means of acceleration electrodes 21a,21b on the semi-conductor cathode 20. In this case, the horizontal deflection means 10" may be dispensed with.

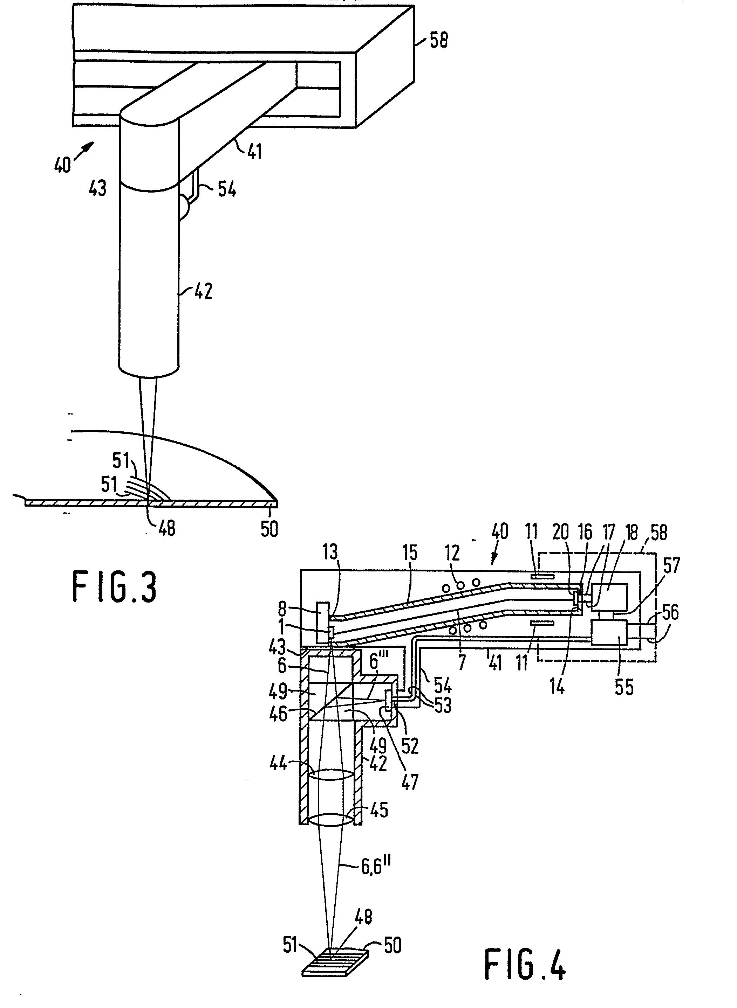

Figure 2 shows diagrammatically in cross-section the construction of a part of such a semiconductor cathode 20 comprising a semiconductor body 22, in this example of silicon. The semiconductor body in this example has an n-type region 24, which adjoins a surface 23 of the semi-conductor body and forms with a p-type region 25 the pn junction 26. Due to the application of a voltage in the reverse direction across the pn junction, electrons are generated by avalanche multiplication, which emanate from the semiconductor body. This is indicated by the arrow 7.

The surface 23 is provided with an electrically insulating layer 27 of, for example, silicon oxide, in which at least one opening 28 is formed. With the opening 28, the pn junction 26 extends substantially parallel to the surface 23. Furthermore, acceleration electrodes 21a,21b, in this example of polycrystalline silicon, are provided on the insulating layer 27 at the edge of the opening 28. The pn junction 26 has within the opening 28 locally a lower breakdown voltage than the remaining part of the pn junction. In this example, the local reduction of the break-down voltage is obtained in that within the opening 28 the depletion zone 30 at the break-down voltage is narrower than at other points of the pn junction 26. The part of the pn junction 26 having the reduced breakdown voltage is separated from the surface 23 by the n-type layer 24. This layer has such a thickness and doping that at the breakdown voltage the depletion zone 30 of the pn junction 26 does not extend as far as the surface 23. As a result a surface layer 31 remains present, which provides for the conduction of the non-emitted part of the avalanche current.

The surface layer 31 is sufficiently thin to allow a part of the electrons generated by avalanche multiplication to pass, these electrons emanating from the semiconductor body 22 and forming the beam 7. Due to a voltage at the acceleration electrodes 21a, 21b, the electrons are subjected to an acceleration. This is generally an additional acceleration because the body 1 generally has a much higher potential than the semiconductor cathode 20.

The construction of the depletion zone 30 and hence the local reduction of the breakdown voltage of the pn junction 26 are obtained in the present example in that a more highly doped p-type region 32 is provided within the opening 28, which forms with the n-type region 24 a pn junction.

The semiconductor device is further provided with a connection electrode (not shown), which is connected via a contact hole to the n-type contact zone 33, which is connected to the n-type zone 24. The p-type zone is contacted in this example on the lower side by means of the metallization layer 34. This contacting preferably takes place via a highly doped p-type contact zone 35.

In the example of Figures 1 and 2, the donor concentration in the n-type region 24 is at the surface, for example, $5.10^{18}$ atoms/cm$^3$, while the acceptor concentration in the p-type region 25 is much lower, for example $10^{15}$ atoms/cm$^3$. The more highly doped p-type region 32 within the opening 28 has at the area of the pn junction an acceptor concentration of, for example, $3.10^{17}$ atoms/cm$^3$. Consequently, at the area of this region 32 the depletion zone 30 of the pn junction 26 is constricted, which results in a reduced breakdown voltage. Thus, the avalanche multiplication will first occur at this area.

The thickness of the n-type region 24 in this example is 0.02 /um. With the said donor concentration, a sufficient number of donors can be ionized to attain the field strength (about $6.10^{15}$ V/cm) at which avalanche multiplication will occur, while nevertheless a surface layer 31 remains present, which on the one hand can provide for the conduction to the pn junction 26 and which on the other hand is sufficiently thin to allow a part of the generated electrons to pass.

The surface 23 may be provided, if desired, with a layer 36 of a material reducing the work function, such as ceasium or barium. For an explanation of the operation and for a few methods of manufacturing such a semiconductor cathode, reference may be made to the aforementioned Netherlands Patent Application No.7905470.

The semiconductor cathode 20 may essentially comprise several semiconductor bodies 22,22', which each may have several openings 28. Moreover, the device may be provided with several first bodies 1,1', which are in this case secured for a satisfactory heat dissipation, for example, on a heat sink 8. For a more detailed description of the operation of the device of Figure 1, reference may be made to Netherlands Patent Application No.8300631. In plan view, the electrodes 21 and the region 32 in this example have an elongate form with a longitudinal axis at right angles to the plane of the drawing of Figure 2. The opening 28 then has a dimension of about 3 $\mu$m x about 250 $\mu$m.

As already stated above, the associated emission pattern is imaged on the active region 2. In the case of practically identical imaging, this region 2 is struck according to a strip-shaped region 3 having a width of about 3 $\mu$m. Due to several scattering, the region in which effective population inversinn occurs will have a width of about 5 $\mu$m. If the body 1 has dimensions of about 200 x 250 $\mu$m, such a strip can be displaced over a distance about 40 times its width. The place of the emanating beam is thus continuously adjustable along the whole end face 9 of the body 1.

The device described can be used in the optical reading unit 40, of which Figure 3 shows a diagrammatic elevation and Figure 4 shows a cross-section.

The reading unit 40 in this example comprises an arm 41, in which a semiconductor cathode 20 is present in a vacuum tube 15, and a first body 1 which is secured on a heat sink 8. The semiconductor cathode 20 and the body 1 are situated on parallel end walls 13 and 14 of the vacuum tube 15, which are not disposed directly opposite each other. In order to deflect the electron beam 7 generated in the cathode and to image the emanating pattern in a ratio of 1 : 1 on the body 1, the device is provided with deflection plates 11 and a coil system 12. As a result, due to the electrical field produced by the deflection plates and coils, the electrons leave the cathode effectively at an angle: positive ions that may be present in the vacuum tube have - due to their larger mass - a small possibility to strike the cathode so that degradation of the cathode due to ion etching is avoided as far as possible. This is described more fully in Netherlands Patent Application No.8104893 of the Applicant.

For electrical connections, the end wall 13 is provided with lead-through members 16, through which connection wires 17 connected to a control unit 18 contact the cathode. From this control unit 18, also the deflection plate 11 and the coil system 12 are controlled.

The lens system 42, which comprises inter alia the lenses 44,45, is optically coupled via a window 43 to the arm 41. For reading the reflected radiation, the lens system comprises a semi-transparent mirror 46, which reflects the beam reflected from the information carrier 50 (with tracks 51) so that the latter strikes one or more photocathodes 47. The signal of the photocathodes 47 can either be read directly or be converted into, for example, a digital signal. Due to the fact that according to the invention the beam 6 can be displaced transverse to the tracks 51 by suitable signals originating from the control unit 18, the beam can scan a number of these tracks adjacent each other, such as, for example, a bar code.

In the above article "Het Systeem "Compact Disc Digital Audio"", published in "Philips Technisch Tijdschrift" 40, p. 262-267, 1981/1982, No.9, there is described how a focusing signal and two tracking error signals can be obtained with the aid of four photodiodes 47. In order to obtain the correct focusing on the information carrier by means of a servo system, the objective 45 is displaceable in the direction of its optical axis by means of a combination of a coil and a permanent magnet not shown further in Figures 3 and 4.

A first tracking error signal is supplied in the system shown by four photodiodes 47. When the luminous spot 48 is situated, viewed in radial direction, at the centre of the track 51, a symmetrical light beam 6" is reflected. When the luminous spot 48 is situated slightly beside the track, the reflected beam 6" becomes asymmetrical due to interference phenomena. This asymmetry is detected by subdividing the reflected beam 6" into two parts by means of the prisms 49. One subbeam 6"' reflected by the mirror 46 then has a higher intensity than the other sub-beam. The signal obtained by coupling the photodiodes 47 in a suitable manner can then be used as error tracking signal.

Due to an asymmetry in the beam by, for example, ageing in the optical system, the luminous spot 48 can be situated beside the centre of track 51 owing to a direct voltage component in the tracking error signal. In order to produce a second tracking error signal for compensating this effect, the luminous spot 48 is displaced radially with respect to the track 51 at a frequency of, for example, 600 Hz. In the reading unit 40, this is effected by causing the active strip 3 and hence the beam 6 to oscillate _via_ control without inertia of the electrodes 21 on the cathode 20 (or of the electro-magnetic deflection system 11,12) in a direction at right angles to the tracks 51. With respect to the known device, the means for producing a mechanical movement of the arm (loudspeaker coil and control) can now be omitted. As a result, the reading unit is also much less sensitive to mechanical shocks. One of the advantages thus obtained is. for example, that a CompactDisc system provided with such a reading unit can be used in an environment which is susceptible to shocks, such as is the case, for example, in automobiles.

The signals of the photodiodes 47 are supplied by means of signal wires 53 _via_   lead-through members 52 and, as the case may be, a wire envelope 54 to a processing unit 55. In this unit the output signals may be processed further, if required, to digital signals. _Via_ signal wires 56, the signals that may be processed are supplied.

The signals of the signal wires 53 are in addition supplied via signal wires  37 for feedback purposes to the control unit 18.

It should be noted that the beam 6 can be moved over several strips or tracks 51 by variation of the strip 3 depending upon the optical properties of the lens system 42. A variation over a large width at low frequency may be advantageous, for example, in the said application for reading information in the form of a bar code on articles. A small, but rapid variation for a tracking error signal may be accompanied by a slow displacement of the arm 41, which is mounted for this purpose, for example, in a carriage 58. If the device shown in Figures 3 and 4 is provided with the means just mentioned for a mechanical movement (loudspeaker coil and control means), this device is suitable to be used for reading information which is determined not only by the presence or absence of pits in the track 51, but also by the length of these pits. Thus, for example, in the VLP system (Video Long Play), the length of such pits is determinative _inter_ _alia_ of the colour code.

When now the luminous spot 48 is caused to oscillate at a sufficiently high frequency and amplitude by means of the device according to the invention, this spot will pass the pit, dependent upon the length of the pit, a larger or smaller number of times. _Via_ the reflected beam 6" and the photodiodes 47, the associated information is then supplied to the processing unit 55. The system with the loudspeaker coil (the mechanical movement) now again provides for the second tracking error signal.

Thus, also for the VLP system a reading unit is obtained, which practically does not comprise a mechanical adjustment for tracking. The tilting mirrors frequently used in the known systems, which should be locked at each displacement, may now be dispensed with, as a result of which a system is obtained that can be more readily manipulated.

The reading units shown above can be used on the other hand as writing units for providing the information on the carrier 50 by focusing the beam 6" in the desired manner with a sufficient intensity on the area of the information to be provided.

Furthermore, the rapid control without inertia of the beam 6" may be used for reading and writing digital information for video tape applications. For example, the area at which the beam 6" strikes a tape to be scanned (or to be written) is then varied over the width of this tape, while at the same time the position of the tape with respect to the unit is kept substantially constant by mechanical means. The information in one information track (which extends over the width of the tape) then corresponds, for example, to one frame of a television picture.

The invention is of course not limited to the examples mentioned above, but several variations are possible for those skilled in the art without departing from the scope of the invention. In the last-mentioned example (VLP system), for example the functions of the mechanical system (supplying a tracking error signal) and of the device according to the invention (supplying a colour coding signal) may be interchanged. The semiconductor cathode 20 need not necessarily be made of silicon. For example, a III-V compound may also be used for this purpose, whilst also several variations are possible with respect to the construction. For the active layer 3, several other materials may also be chosen.

1.          A device for producing coherent electromagnetic
radiation comprising at least a first body provided with a
first layer of a material suitable for producing electro-
magnetic radiation having an active region, in which in the
operative condition,  population inversion is obtained by
means of electron injection, which device comprises at least
a cathode for generating an electron beam striking the
active region and causing population inversion for producing
the electromagnetic radiation in a strip of the active
region which is narrow with respect to the width of the
active region, while by control of the electron beam the
position of the strip in the active region and hence the
position of the emanating radiation can be varied,
characterized in that the device comprises a semiconductor
cathode for generating an electron beam.

2.          A device as claimed in Claim 1, characterized
in that the semiconductor cathode comprises a semiconductor
body having a pn junction between an $\underline{n}$-type region adjoining
a surface of the semiconductor body and a $\underline{p}$-type region,
wherein due to the application of a voltage in the reverse
direction across the pn-junction in the semiconductor body
electrons are generated by avalanche multiplication, which
emanate from the semiconductor body, the pn junction at
least locally extending parallel to the surface and having
a lower breakdown voltage than the remaining part of the
pn junction, the part having the lower breakdown voltage
being separated from the surface by an $\underline{n}$-type conducting
layer having such a thickness and doping that at the break-
down voltage the depletion zone of the pn junction does not
extend as far as the surface, but remains separated therefrom by a surface layer which is sufficiently thin to allow
the generated electrons to pass while the surface of the semiconductor body is provided with an insulating layer in which at least one opening is formed, at least one acceleration electrode being provided on the insulating layer along the edge of the opening and the pn junction extending at least within the opening substantially parallel to the surface and locally having a lower breakdown voltage.

3. A device as claimed in Claim 2, characterized in that the opening in the oxide has the form of a narrow gap.

4. A device as claimed in any one of the preceding Claims, characterized in that the active region is at least ten times wider than the region in which population inversion is obtained.

5. A device as claimed in any one of the Claims 1 to 4, characterized in that the first layer comprises monocrystalline semi-conductor material from a II-VI compound or a III-V compound.

6. A device as claimed in any one of Claims 1 to 5, characterized in that the device comprises a vacuum tube in which the first body and the semiconductor cathode are disposed in an evacuated envelope, the first body being situated at the area of an end wall of the vacuum tube and the surface of the first body and that of the semiconductor cathode being situated in substantially parallel planes.

7. A device as claimed in any one of Claims 1 to 6, characterized in that the device has such electro-magnetic deflection means that an emission pattern of the semi-conductor can be imaged on the surface of the first body practically in a ratio of 1 : 1.

8. An optical reading unit for scanning a record carrier which is provided with a radiation-reflecting information structure arranged in the form of a strip, this reading unit comprising an objective system for focusing a reading beam on the information structure and a radiation source as well as a deflection unit for the reflected beam, characterized in that the radiation source comprises a device as claimed in any one of Claims 1 to 7.

9.      An optical reading unit as claimed in Claim 8, characterized in that the detection unit can generate a binary signal which is related to the width of the strip-shaped parts of the information structure or the complement thereof.

10.      An optical reading unit for scanning a record carrier by moving the record carrier and the reading unit relative to each other, which record carrier is provided with a reflecting information structure arranged in the form of a track, the reading unit comprising an objective system for focusing a reading beam on the information structure and a radiation source as well as a detection unit for the reflected beam, characterized in that the radiation source comprises a device as claimed in any one of Claims 1 to 9.

11.      An optical reading unit as claimed in Claim 10, characterized in that the detection unit can generate a feedback signal for the device for producing the electro-magnetic radiation.

12.      An optical writing unit for writing a record carrier having a radiation-reflecting information structure arranged in the form of a track, this writing unit comprising an objective system for focusing a writing beam on the record carrier to be written and a radiation source aw well as a detection unit for a reflected beam, characterized in that the radiation source comprises a device as claimed in any one of Claims 1 to 7.

13.      An optical writing unit for writing a record carrier by moving the record carrier to be written and the writing unit relative to each other, the record carrier having a radiation-reflecting information structure arranged in the form of a track, the writing unit comprising .an objective system for focusing a writing beam on the record carrier to be written and a radiation source as well as a detection unit for a reflected beam, characterized in that the radiation source comprises a device as claimed in any one of Claims 1 to 7.

FIG.1

FIG.2

0156412

58

40

41

43

54

42

51
51

48          50

# FIG.3

40  11  20  16  17  18  58

13      15    12                        57

8                                          56

1

43

6          6'''                            54

49                                        53

46

49                                        52

44        42        47

45                        14        55

7    41    11

6,6''

51              48
                50

# FIG.4

2-Ⅱ- PHN  10947

## European Patent Office

## EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| D,Y | US-A-3 655 986 (B.LAX) <br> * Column 4, lines 2-33; column 7, line 46 - column 8, line 21; figures 1,4 * | 1,4-6 | H 01 S 3/09 <br> H 01 S 3/101 <br> H 01 J 1/30 <br> G 11 B 7/125 <br> G 11 B 7/09 <br> G 06 K 7/14 |
| Y | GB-A-2 054 959 (PHILIPS) <br> * Page 2, lines 31-56; page 10, lines 4-11; figures 2,5 * & NL - A - 7 905 470 (Cat. D,Y) | 1,2,6 | |
| A | US-A-3 715 162 (D.A.CAMPBELL et al.) <br> * Column 10, lines 37-52; figure 7 * | 1,12, 13 | |
| A | PATENTS ABSTRACTS OF JAPAN, vol. 5, no. 149 (E-75)[821], 19th September 1981; & JP - A - 56 81 992 (DAINI SEIKOSHA K.K.) 04-07-1981 <br> * Abstract * | 1,10 | TECHNICAL FIELDS SEARCHED (Int. Cl.4) <br><br> H 01 S <br> H 01 J |
| A | FR-A-2 360 957 (PHILIPS) <br> * Page 12, line 27 - page 13, line 31 * | 8,10 | |

--- -/-

The present search report has been drawn up for all claims

| Place of search | Date of completion of the search | Examiner |
|---|---|---|
| THE HAGUE | 10-06-1985 | BORMS F. |

0156412

European Patent Office

EUROPEAN SEARCH REPORT

Application number

EP  85 20 0247

Page  2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| P,Y | EP-A-0 119 646  (PHILIPS)<br><br>* Claims 1,2,7-10; page 9, line 26 – page 4, line 10; page 5 lines 29-35; page 6, lines 25-37; page 7, lines 18-30; page 8, lines 3-11; figures 1,5 *<br><br>----- | 1-3,5, 6 | |

TECHNICAL FIELDS SEARCHED (Int. Cl.4)

The present search report has been drawn up for all claims

| Place of search | Date of completion of the search | Examiner |
|---|---|---|
| THE HAGUE | 10-06-1985 | BORMS F. |